# EUROPEAN PATENT APPLICATION

(11) **EP 1 538 450 A1**
(43) Date of publication of application: **08.06.2005**
(21) Application number: 04300816.8
(22) Date of filing: 25.11.2004
(51) Int. Cl.: G01R 21/133, G01R 25/04

(54) **Electrical power meter**

(30) Priority: 04.12.2003 GB 0328139
(71) Applicant: Actaris UK Limited, Felixstowe, Suffolk IP11 2ER (GB)
(72) Inventor: Brown, Scott, Saxmundham, Suffolk IP17 1BE (GB); Chen, Chun, Ipswich IP1 2 (GB)
(74) Representative: Feray, Valérie

(57) **Abstract**

The present invention relates to the field of electrical power meter utilizing digital signal processing in order to provide the consumption of electrical energy by integration of said electrical power. Said meter (1) comprises a voltage sensor (4), a current sensor (3), an analogue to digital converter (8) including first sampling means for generating a first voltage sample at a first sampling time and second sampling means for generating a first current sample at a second sampling time. Said meter further comprises phase compensation means (9) for compensating phase shifts between said analogue voltage and current signals by adjusting said second sampling time compared to said first sampling time in order to provide said first voltage sample and said first current sample substantially in phase, means (6,12 and 13) for saturating said voltage and current analog signals in order to produce voltage and current substantially square waves and means (15) for evaluating said shifting of sampling time by taking the differences between the zero crossing time of said current square wave and the zero crossing time of said voltage square wave.

## Description

The present invention relates to the field of electrical power meter utilizing digital signal processing in order to provide the consumption of electrical energy by integration of said electrical power.

It is well known to provide electrical utility meter allowing the measurement of electrical energy consumed by a facility. Such a meter converts analogue signals proportional to current and voltage in the power line being metered to digital signals for digital signal processing. Such a conversion step is provided by an analogue to digital converter. The digital signals can then be readily multiplied and the product of multiplication provides the electrical power. The electrical power is then provided to an accumulator which generates pulses proportional to the power used on the power line being metered.

One problem encountered by such a known electrical utility meter is that the accuracy of such meter requires that the voltage and current signals be in the correct phase relationship before each is provided to the analogue to digital converter. That is, the phase relationship should accurately represent the phase relationship in the power line. However, the voltage and current filtering, amplification and isolation are accomplished through circuitry including instrument transformers and other circuit elements which may introduce phase differences or errors between them.

A known solution to this problem, in order to obtain the required accuracy and to compensate for manufacturing errors in the instrument transformers and changes in circuit elements with time and environmental exposure, is to provide phase compensating means for the electrical meter. Such a solution is disclosed in the document US5017860 which discloses a meter comprising compensation means to adjust the time of sampling of one signal (current or voltage) relative to the other to compensate the phase shifts in the system and provide a more accurate indication of power used on the power line.

However, this solution raises some difficult problems. The phase shifts may indeed vary depending on the tolerances of the components used in amplification and filtering stages. Therefore, said means to adjust the time of sampling may not be efficient anymore in case of such a variation of phase shifts.

One object of the present invention is to provide a meter for metering electrical power on a power load that allows good measurement accuracy by taking into account the correct phase relationship even in case of variation of phase shifts.

More precisely, the present invention provides a meter for metering the electrical power comprising:
- a voltage sensor in order to generate an analogue voltage signal responsive to a voltage provided to said load,
- a current sensor in order to generate an analogue current signal responsive to a current provided to said load,
- an analogue to digital converter including:
   o first sampling means for generating a first voltage sample based on said analogue voltage signal at a first sampling time,
   o second sampling means for generating a first current sample based on said analogue current signal at a second sampling time,
- phase compensation means for compensating phase shifts between said analogue voltage and current signals by adjusting said second sampling time compared to said first sampling time in order to provide said first voltage sample and said first current sample substantially in phase,
said meter being characterized in that it further comprises:
- means for saturating said voltage and current analog signals in order to produce voltage and current substantially square waves,
- means for evaluating said shifting of sampling time by taking the differences between the zero crossing time of said current square wave and the zero crossing time of said voltage square wave.

Thus, by use of this meter, an evaluation of the phase shift is made in real time in order to make a needed correction on phase compensation means. This can be done by saturating sinusoidal voltage and current analog signals in order to produce square waves and by providing said square waves to a microcontroller in order to evaluate the shifting of sampling time. Therefore, according to the invention, there is an auto-calibration of phase shift correction delays.

Advantageously, said means for saturating said voltage and current analog signals are a zero crossing detect circuit.

Advantageously, said means for saturating said current analog signal is a saturating amplifier.

Advantageously, said phase compensation means are a timer integrated in said analogue to digital converter.

Advantageously, said meter comprises a microcontroller, said microcontroller including:
- said analogue to digital converter,
- interrupt inputs receiving said voltage and current substantially square waves and detecting the zero crossing points of said voltage and current substantially square waves.

Other characteristics and advantages of the invention will appear reading the following description of an embodiment of the invention, given by way of example and with reference to the accompanying drawing, in which:

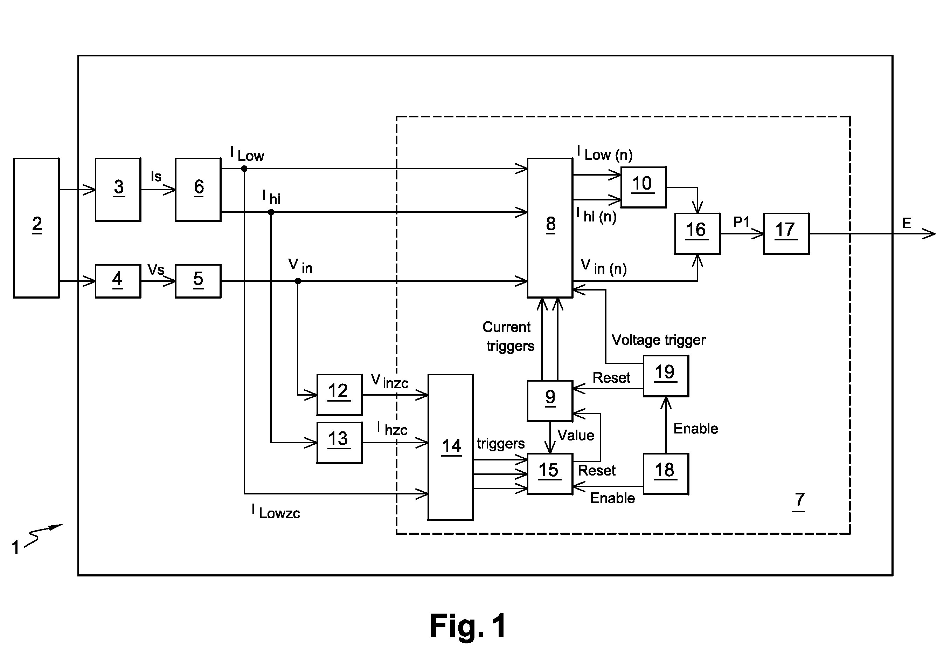

- Figure 1 shows schematically a block diagram of a meter according to the present invention.

Figure 1 shows schematically a meter 1 according to the invention.

In general, said meter 1 is operably connected to a power lines load 2 of a power consuming facility, not shown, such as a residence or industrial establishment.

The meter 1 comprises:
- a current sensor 3,
- a voltage sensor 4,
- voltage level adjustment means 5,
- current level adjustment means 6,
- a voltage zero-crossing detect circuit 12,
- a current zero-crossing detect circuit 13,
- a microcontroller 7.

Said microcontroller 7 includes :
- an analogue to digital AID converter 8 including,
- a phase adjust timer 9 comprising a compare register,
- an input selector 10,
- a module having interrupt inputs 14,
- a phase shift measuring device 15,
- a calibration control device 18,
- a sample timer 19
- a multiplier 16,
- an integrator 17.

The voltage sensor 4 is connected to the power lines 2 and is operable to generate a voltage measurement signal Vs representative of the voltage waveform on the power lines 2. Said voltage sensor 4 may be for instance a simple resistor divider. The Vs signal is then adjusted by the voltage level adjustment means 5 outputting an adjusted voltage measurement signal Vin. Said voltage level adjustment means 5 are used in order to provide a correct signal level to the A/D converter 8. One has to note that said voltage level adjustment means 5 might also have a filtering function.

The current sensor 3 is also connected to the power lines 2 and is operable to generate a current measurement signal Is representative of the current waveform on the power lines 2. Said current sensor may be for instance a shunt resistance used to derive the current. The Is signal is then adjusted by the current level adjustment means 6 outputting two adjusted current measurement signals Ilow and Ihi. The Ihi and Ilow signals represent the same Is signal respectively adjusted with two different gains A1 and A2. This allows a good A/D converter inputs range across the whole current range (for instance 10 mA to 100 A). A1 is for example used to produce the appropriate signal Ihi for main currents of 4 to 100 A and A2 is used to produce the appropriate signal Ilow for main currents of 10 mA to 4 A. As for the voltage adjustment means 5, one has to note that the current adjustment means 6 may also have a filtering function.

The A/D converter 8 generates a sampled voltage measurement data stream comprising a plurality of voltage measurement samples Vin(1), Vin(2), Vin(3),...Vin(n) based on the voltage measurement signal Vin provided by the voltage adjustment means 5.

Identically, said A/D converter 8 generates a first sampled current measurement data stream comprising a plurality of current measurement samples Ihi(1 ), Ihi(2), Ihi(3),...Ihi(n) based on the current measurement signal Ihi provided by the current adjustment means 6 and a second sampled current measurement data stream comprising a plurality of current measurement samples Ilow(1), Ilow(2), Ilow(3),...Ilow(n) based on the current measurement signal Ilow provided by the current adjustment means 6.

One problem is that adjustment and filtering steps introduce phase shifts in the different analogue signals; such phase shifts have to be taken into account when sampling the signals. Such a situation is particularly true with the current adjustment means 6 used to adjust the signal Is. The adjustment provided by the current adjustment means 6 causes some phase shifting of Ihi and Ilow and further phase shifting occurs when low-pass filtering is added to the signal in order to reduce the noise and improve the signal-to-noise ratio; this last point is critical in case of Ilow that is extremely shifted in phase. Therefore, there is always a first phase shift that is not very high between Vin and Ihi and a second higher phase shift between Vin and Ilow.

In order to get voltage and current samples corresponding to voltage and current signals that are substantially in phase, the microcontroller 7 comprises a phase adjust timer 9 for compensating phase shifts between said analogue voltage Vin and said current signal Ihi and between said analogue voltage Vin and said current signal Ilow. Such compensation is obtained by adjusting the sampling time of Ihi and Ilow compared to the sampling time of Vin in order to provide a voltage sample and current samples substantially in phase.

However, the phase shifts may vary depending on the tolerances of the components used in amplification and filtering stages. Therefore, phase adjust timer 9 must be efficient even in case of such a variation of phase shifts.

By use of the meter 1, an evaluation of the phase shift is made in real time in order to make a needed correction on said phase adjust timer 9.

In order to obtain such a result, a 10A signal is injected into the current input signal, in-phase with a voltage signal. This signal will force a virtual substantially square wave Ilowzc on the Ilow signal, which is passed into an interrupt input of the module 14. Such saturation may be obtained for instance by saturating an operational amplifier having an A2 gain and included in current level adjustment means 6.

The Ihi and Vin signals do not actually require the 10A signal as they have zero crossing-point detection circuits respectively 13 and 12. The substantially square wave outputs Ihizc and Vinzc from these circuits are also passed into interrupt inputs of the module 14. Each of the zero crossing point circuit 12 or 13 will produce a square-wave output of constant amplitude when any signal is input that crosses a pre-defined voltage threshold. The output will be high when the input is above the threshold, and low when the input is below the threshold. In this way, the output can be used to provide clean edges that can be used as interrupt inputs to the microcontroller.

The interrupt inputs of the module 14 are triggered by the various crossing-point signals, either by a positive-going edge or a negative-going edge, depending on the architecture of the microcontroller and the independent setup of the interrupt inputs. Some are configurable, some are not, depending on the specific microcontroller chosen. The interrupt inputs are configured to halt normal execution of the microcontroller software and to run a service routine immediately.

Calibration is performed by a calibration equipment (not shown in figure 1) that can inject a load through the meter and control the meter by means of a communications interface providing a set of commands as appropriate for the necessary actions.

The calibration control module 18 is told by the calibration equipment to enable the phase shift calibration.

The phase shift measuring device 15 receives 3 edges from the interrupt inputs for Vinzc, Ihizc and Ilowzc.

When the Vinzc edge is captured, the phase adjust timer 9 is reset.

The phase adjust timer 9 is a 16-bit timer and runs at around 2Mhz. This provides a range up to 40,000 for a 50Hz signal, or 33,333 for a 60Hz signal. This allows for a resolution of around 1/100^{th} of a degree, which is exceptionally accurate.

When either of the Ihizc or Ilowzc edge is captured the phase adjust timer value 9 is read and added to one of two accumulators included in said timer 9 (one for each I signal).

This is repeated until 50 samples of each signal have been accumulated.

Each accumulator is then divided by 50 to average the phase shift, creating two constants Ihi_sample_delay and Ilow_sample_delay. These are then permanently stored in the meter as part of the calibration process.

The 10A signal is removed and the calibration control is told to disable the phase shift calibration.

The sample timer 19 is a 8-bit timer and runs at around 1kHz (1024Hz in our implementation) and triggers the initial sample of Vin(n).

The sample timer 19 also resets the phase adjust timer 9, and loads the Ihi_sample_delay constant into the compare register included in said phase adjust timer 9.

When the phase adjust timer 9 reaches the compare register value it triggers the sample of Ihi(n). The phase adjust timer 9 is reset again and the value of (Ilow_sample_delay - Ihi_sample_delay) is loaded into it's compare register.

When the phase adjust timer 9 again reaches the compare register value it triggers the sample of Ilow(n). The phase adjust timer 9 is stopped.

The role of the input selector 10 is to select one of the two current samples, between for instance Ihi(n) and Ilow(n), that is going to be used for the calculation of the power. Such a selection is based on the level of Ihi(n) and Ilow(n). Let's assume that Ilow(n) is selected.

The samples Vin(n) and Ilow(n) provide the inputs to the multiplier 16 which multiplies Vin(n) by Ilow(n) to provide a digital input signal P1 to the integrator 17 that is going to provide an accumulated energy E.

Naturally, the present invention is not limited to the example and embodiment described and shown, and the invention can be the subject to numerous variants that are available to the person skilled in the art.

For instance, because the signals may vary in phase shift, they may arrive in any order. For the disclosed embodiment, we have assumed that llowzc lags Ihizc at all times, due to the cascaded nature of the circuitry. Of course, the meter according to the invention may allow for them to be received in either order.

Besides, the meter according to the invention has been described as having two types of current signals Ih and Ilow but it may also have only one type of current.

## Claims

1. Meter (1) for metering electrical power comprising:
- a voltage sensor (4) in order to generate an analogue voltage signal responsive to a voltage provided to said load,
- a current sensor (3) in order to generate an analogue current signal responsive to a current provided to said load,
- an analogue to digital converter (8) including:
o first sampling means for generating a first voltage sample based on said analogue voltage signal at a first sampling time,
o second sampling means for generating a first current sample based on said analogue current signal at a second sampling time,
- phase compensation means (9) for compensating phase shifts between said analogue voltage and current signals by adjusting said second sampling time compared to said first sampling time in order to provide said first voltage sample and said first current sample substantially in phase,
said meter (1) being **characterized in that** it further comprises:
- means (6, 12, 13) for saturating said voltage and current analog signals in order to produce voltage and current substantially square waves,
- means (15) for evaluating said shifting of sampling time by taking the differences between the zero crossing time of said current square wave and the zero crossing time of said voltage square wave.

2. A Meter (1) according to claim 1 further wherein said means for saturating said voltage and/or current analog signals are a zero-crossing detect circuit (12, 13).

3. A Meter (1) according to any one of claims 1 or 2 wherein said means for saturating said current analog signal is a saturating amplifier.

4. A Meter (1) according to any one of the preceding claims wherein said phase compensation means are a timer (9) integrated in said analogue to digital converter.

5. A Meter (1) according to any one of the preceding claims comprising a microcontroller (7), said microcontroller (7) including:
- said analogue to digital converter (8),
- interrupt inputs (14) receiving said voltage and current square waves and detecting the zero crossing points of said voltage and current substantially square waves.

6. A Meter substantially as herein described with reference to, or as illustrated in, the accompanying drawings.
